# EUROPEAN PATENT APPLICATION

(11) **EP 4 517 836 A1**
(43) Date of publication of application: **05.03.2025**
(21) Application number: 24154577.1
(22) Date of filing: 30.01.2024
(51) Int. Cl.: H01L 29/786, H01L 29/78

(54) **FIELD-EFFECT TRANSISTORS WITH AN ASYMMETRIC DEFECT REGION**

(30) Priority: 28.08.2023 US 202318238585
(71) Applicant: GLOBALFOUNDRIES Singapore Pte. Ltd., Singapore 738406 (SG)
(72) Inventor: DENG, Wensheng, 738406 Singapore (SG); TOH, Rui Tze, 738406 Singapore (SG); LIU, Xinfu, 738406 Singapore (SG); CHEN, Xin, 738406 Singapore (SG); LIN, Kemao, 738406 Singapore (SG); WONG, Jason Kin Wei, 738406 Singapore (SG); CHONG, Yung Fu, 738406 Singapore (SG)
(74) Representative: Lambacher, Michael

(57) **Abstract**

Structures for a field-effect transistor and methods of forming a structure for a field-effect transistor. The structure comprises one or more semiconductor layers, a gate on the one or more semiconductor layers, a source/drain region including a first portion in the one or more semiconductor layers and a second portion in the one or more semiconductor layers, and a defect region in the one or more semiconductor layers. The defect region is disposed adjacent to the first portion of the source/drain region.

## Description

### BACKGROUND

The present disclosure relates to integrated circuits and semiconductor device fabrication and, more specifically, to structures for a field-effect transistor and methods of forming a structure for a field-effect transistor.

A field-effect transistor generally includes a source, a drain, a body contributing a channel region between the source and drain, and a gate electrode overlapped with the channel region. When a control voltage exceeding a characteristic threshold voltage is applied to the gate electrode, carrier flow occurs in the channel region of the body between the source and drain to produce a device output current.

A silicon-on-insulator substrate includes a bulk substrate, a device layer, and an electrical insulator layer disposed between the device layer and the bulk substrate. An advantage of forming a field-effect transistor using a silicon-on-insulator substrate is reduced parasitic capacitance due to electrical isolation of the device layer from the bulk substrate. The depletion region of the field-effect transistor may extend only partially through the device layer during operation. Partially-depleted field-effect transistors suffer from the floating body effect in which the body in the device layer forms a capacitor against the insulated bulk substrate and charge accumulates on this capacitor. The accumulated charge adversely affects device performance.

Structures for a field-effect transistor and methods of forming a structure for a field-effect transistor are needed.

### SUMMARY

In an embodiment of the invention, a structure for a field-effect transistor is provided. The structure comprises one or more semiconductor layers, a gate on the one or more semiconductor layers, a source/drain region including a first portion in the one or more semiconductor layers and a second portion in the one or more semiconductor layers, and a defect region in the one or more semiconductor layers. The defect region is disposed adjacent to the first portion of the source/drain region.
The one or more semiconductor layers may include a first semiconductor layer and a second semiconductor layer on the first semiconductor layer; the second semiconductor layer may be disposed fully between the defect region and the gate.
Further, the first portion of the first source/drain region may be disposed in the first semiconductor layer, and the second portion of the first source/drain region may be disposed in the second semiconductor layer.
Further, the first semiconductor layer may adjoin the second semiconductor layer along an interface; the gate may be disposed on the second semiconductor layer; the interface may be disposed between the defect region and the second portion of the first source/drain region.
Further, the structure may further comprise a substrate, and a dielectric layer on the substrate, wherein the first semiconductor layer may adjoin the second semiconductor layer along an interface, and the defect region may be disposed fully between the second semiconductor layer and the dielectric layer. Optionally, the structure may comprises a silicon-on-insulator substrate that may include the first semiconductor layer, the dielectric layer, and the substrate.
Further, the second semiconductor layer may be a homoepitaxial layer that may comprise the same semiconductor material as the first semiconductor layer.
Further, the defect region may surround the first portion of the first source/drain region; further, the first source/drain region may be a source region of the field-effect transistor.
Further, the structure may further comprise a second source/drain region in the one or more semiconductor layers, and a channel region in the one or more semiconductor layers, the channel region disposed beneath the gate between the first source/drain region and the second source/drain region; the channel region may be disposed between the defect region and the second source/drain region. Optionally, the first source/drain region may be a source region of the field-effect transistor, and the second source/drain region may be a drain region of the field-effect transistor.
Further, the channel region may be adjacent to the defect region; further, the defect region may be disposed between the channel region and the first source/drain region. The channel region may be free of defects; further, the second source/drain region may free of defects.
Further, the defect region may comprise dislocations.

In an embodiment of the invention, a method of forming a structure for a field-effect transistor is provided. The method comprises forming a defect region in a first semiconductor layer, forming a second semiconductor layer on the first semiconductor layer, forming a gate on the second semiconductor layer, and forming a source/drain region including a first portion in the first semiconductor layer and a second portion in the second semiconductor layer. The defect region is disposed adjacent to the first portion of the source/drain region.
The second semiconductor layer may be formed after forming the defect region in the first semiconductor layer; further the source/drain region may be formed in a portion of the second semiconductor layer and the recrystallized semiconductor material of the first semiconductor layer.
Further, the step of forming the defect region in the first semiconductor layer may comprise: disordering a crystal structure of a portion of the first semiconductor layer; and converting the portion of the first semiconductor layer to recrystallized semiconductor material and the defect region.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIG. 1 is a cross-sectional view of a structure at an initial fabrication stage of a processing method in accordance with embodiments of the invention.
FIG. 2 is a cross-sectional view of the structure at a fabrication stage of the processing method subsequent to FIG. 1.
FIG. 3 is a cross-sectional view of the structure at a fabrication stage of the processing method subsequent to FIG. 2.
FIG. 4 is a cross-sectional view of the structure at a fabrication stage of the processing method subsequent to FIG. 3.

### DETAILED DESCRIPTION

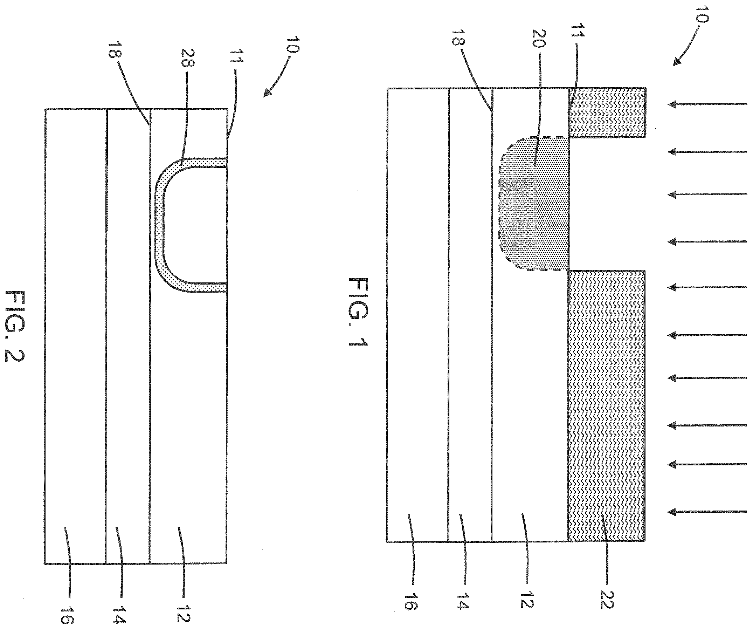

With reference to FIG. 1 and in accordance with embodiments of the invention, a device structure 10 for a transistor may be fabricated using a silicon-on-insulator substrate that includes a semiconductor layer 12, a substrate 16, and a dielectric layer 14 disposed between the semiconductor layer 12 and the substrate 16. The semiconductor layer 12 may be comprised of a semiconductor material, such as single-crystal silicon. The dielectric layer 14 may be comprised of a dielectric material, such as silicon dioxide, that is an electrical insulator. The substrate 16 may be comprised of a semiconductor material, such as single-crystal silicon. The semiconductor layer 12 and the dielectric layer 14 adjoin along an interface 18. In an embodiment, the semiconductor layer 12 may have a thickness in a range of about 50 nanometers to about 200 nanometers.

A damaged region 20 may be formed in the semiconductor layer 12 by, for example, ion implantation under a given set of implantation conditions. A patterned implantation mask 22 may be formed on a top surface 11 of the semiconductor layer 12 to define a selected area that is exposed for the implantation of ions, as indicated by the single-headed arrows. The implantation mask 22 may include a layer of a photoresist that is applied and patterned to form an opening exposing the selected area and determining, at least in part, the location and horizontal dimensions of the damaged region 20. The implantation mask 22 has a thickness and stopping power sufficient to block the implantation of ions in the masked area. The implantation mask 22 may be stripped after the damaged region 20 is formed.

The implantation conditions, such as ion species, dose, kinetic energy, tilt angle, may be selected to tune the physical characteristics, such as depth and damage level, of the damaged region 20 in the semiconductor layer 12. In an embodiment, the implanted ion species may be electrically inactive in the semiconductor material of the semiconductor layer 12. In an embodiment, the damaged region 20 may be formed by implanting ions of germanium or carbon. In an embodiment, the damaged region 20 may be formed by co-implanting germanium ions and carbon ions. In an embodiment, the damaged region 20 may be formed by implanting ions generated from an inert gas, such as argon or xenon.

The kinetic energy and dose of the implanted ion species needed to produce the damaged region 20 may be dependent upon, among other factors, the thickness of the semiconductor layer 12. In an embodiment, the damaged region 20 may be formed by implanting germanium ions at a kinetic energy of 30 keV to 45 keV. In an embodiment, the damaged region 20 may be formed by implanting argon ions at a kinetic energy of 50 keV to 70 keV. In an embodiment, the damaged region 20 may be formed by implanting xenon ions at a kinetic energy of 40 keV to 60 keV. In embodiments, the ion dose of germanium ions or xenon ions may range from 3×10¹⁴ ions per square centimeter to 1×10¹⁵ ions per square centimeter.

The implantation process generates a distribution of damage in the damaged region 20 that may exhibit a maximum damage level near the projected range of the implanted ions. The ion implantation process forming the damaged region 20 introduces energetic ions with ion trajectories that travel in paths within the semiconductor layer 12. The energetic ions lose energy along their paths via stochastic scattering events with atomic nuclei and electrons in the traversed semiconductor material of the semiconductor layer 12, and eventually stop in the semiconductor layer 12 after their energy is dissipated. Energy lost in nuclear collisions displaces target atoms of the semiconductor layer 12 from their original lattice sites, which damages the crystal lattice structure. The crystal lattice structure of the semiconductor layer 12 is highly disordered within the damaged region 20, especially near the projected range, in comparison with undamaged semiconductor material in regions of the semiconductor layer 12 that are masked by the implantation mask 22 and a region of the semiconductor layer 12 beneath the damaged layer 20. In an embodiment, the crystal lattice structure of the semiconductor layer 12 may be amorphized within the damaged region 20.

In an embodiment, the damaged region 20 may extend from the top surface 11 of the semiconductor layer 12 to a depth that is less than the thickness of the semiconductor layer 12. Regions of the semiconductor layer 12 adjacent to the damaged region 20 are protected by the implantation mask and undamaged by the ion implantation, as is a portion of the semiconductor layer 12 between the damaged region 20 and the dielectric layer 14.

With reference to FIG. 2 in which like reference numerals refer to like features in FIG. 1 and at a subsequent fabrication stage of the processing method, a defect region 28 may be formed from the damaged region 20 by performing an annealing process. In an embodiment, the annealing process may heat the silicon-on-insulator substrate to a peak temperature of greater than or equal to 850°C. In an embodiment, the annealing process may be a rapid thermal anneal. In an embodiment, the annealing process may be a furnace anneal.

The crystal structure of the semiconductor layer 12 in the damaged region 20 between the damaged region 20 and a top surface 11 of the semiconductor layer 12 may be recrystallized by the annealing process. The recrystallized semiconductor material may have substantially the same crystallinity and crystal structure as the original crystallinity and crystal structure of the semiconductor layer 12. The crystal structure of the semiconductor layer 12 in the defect region 28 may include a distribution of defects, such as dislocations. A dislocation may be a linear crystallographic defect or irregularity within the crystal structure of the semiconductor layer 12 that contains an abrupt change in the arrangement of atoms. In an embodiment, the defects in the defect region 28 may coincide with the end-of-range for the implantation process forming the damaged region 20. The defect region 28 is fully disposed between the top surface 11 of the semiconductor layer 12 and the interface 18 between the semiconductor layer 12 and the dielectric layer 14.

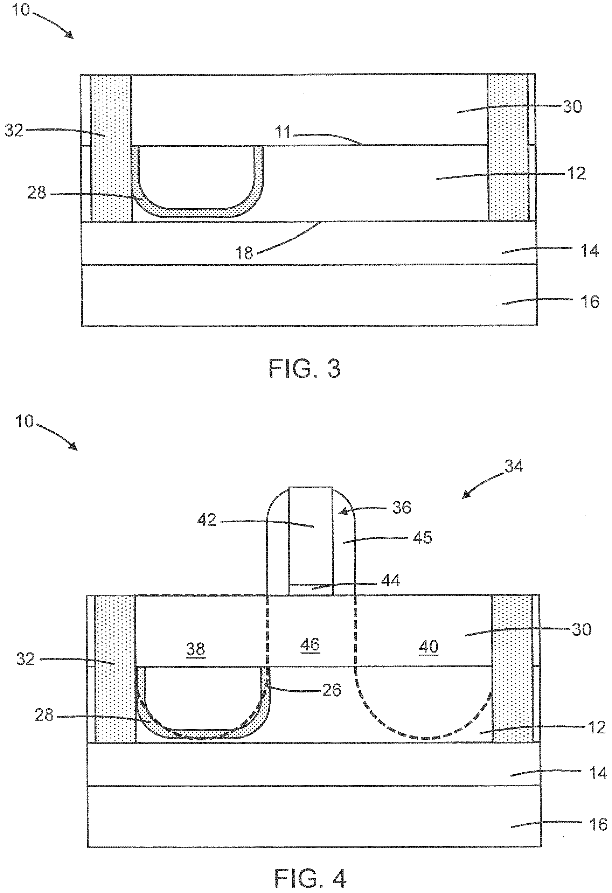

With reference to FIG. 3 in which like reference numerals refer to like features in FIG. 2 and at a subsequent fabrication stage of the processing method, a semiconductor layer 30 may be formed on the top surface 11 of the semiconductor layer 12. In an embodiment, the semiconductor layer 30 may be formed by an epitaxial growth process and may contain single-crystal semiconductor material, such as single-crystal silicon. The single-crystal semiconductor material of the semiconductor layer 12 has a crystal structure that serves as a crystalline template during epitaxial growth for the crystal structure of the single-crystal semiconductor material of the semiconductor layer 30. In an embodiment, the semiconductor layer 30 may be a homoepitaxial layer that is comprised of the same semiconductor material as the semiconductor layer 12.

The semiconductor layer 30 adjoins the semiconductor layer 12 along an interface that is coextensive with the top surface 11 of the semiconductor layer 12. The defect region 28 is fully disposed in the semiconductor layer 12 between the semiconductor layer 30 and the dielectric layer 14. The defect region 28 does not extend into the semiconductor layer 30 because the defect region 28 is formed before the semiconductor layer 30 is formed and the defects do not propagate into the semiconductor layer 30 during epitaxial growth. As a result, the semiconductor layer 30 may be free of defects, such as dislocations.

A trench isolation region 32 may be formed that extends through the semiconductor layer 30 and the semiconductor layer 12 to the dielectric layer 14. The trench isolation region 32 surrounds an active region that includes a portion of the semiconductor layer 12 and a portion of the semiconductor layer 30. The surrounded portion of the semiconductor layer 12 in the active region includes the defect region 28. The trench isolation region 32 may be formed by a shallow trench isolation technique that patterns a trench in the semiconductor layers 12, 30 with lithography and etching processes, deposits a dielectric material to fill the trench, and planarizes the dielectric material using chemical mechanical polishing and/or an etch back. The dielectric material contained in the trench isolation region 32 may be comprised of a dielectric material, such as silicon dioxide, that is an electrical insulator.

With reference to FIG. 4 in which like reference numerals refer to like features in FIG. 3 and at a subsequent fabrication stage of the processing method, a field-effect transistor 34 may be formed in the active region. In an embodiment, the field-effect transistor 34 may be deployed in a low-noise amplifier found in a radio-frequency circuit. In an embodiment, the field-effect transistor 34 may be deployed in a power amplifier found in a radio-frequency circuit.

The field-effect transistor 34 may include a gate 36, a source/drain region 38, and a source/drain region 40. The gate 36 may include a gate electrode 42 and a gate dielectric layer 44 that is disposed between the gate electrode 42 and the semiconductor layer 30. The gate electrode 42 is comprised of a conductor, such as doped polysilicon and/or a work function metal. The gate dielectric layer 44 is comprised of a dielectric material, such as silicon dioxide or hafnium oxide, that is an electrical insulator. The gate electrode 42 and gate dielectric layer 44 may be formed by patterning layers of their respective materials with lithography and etching processes. The gate 36 is disposed in a lateral direction between the source/drain region 38 and the source/drain region 40. The gate 36 may be placed such that the defect region 28 is adjacent to the same sidewall of the gate 36 as the source/drain region 38. The semiconductor layer 30 is disposed fully between the defect region 28 and the gate 36, as well as between the semiconductor layer 12 and the gate 36.

The source/drain region 38 and the source/drain region 40, which are indicated by dashed lines in FIG. 4, are disposed in the semiconductor layers 12, 30 adjacent to the opposite sidewalls of the gate 36. The source/drain region 38 has an upper portion in the semiconductor layer 30 and a lower portion in the semiconductor layer 12. The source/drain region 40 also has an upper portion in the semiconductor layer 30 and a lower portion in the semiconductor layer 12.

The source/drain region 38 and the source/drain region 40 may be formed by self-aligned ion implantation of a dopant under given set of implantation conditions into the semiconductor layers 12, 30. The implantation conditions, such as ion species, dose, kinetic energy, and tilt angle, may be selected to tune the electrical and physical characteristics of the source/drain region 38 and the source/drain region 40. In an embodiment, the source/drain region 38 and the source/drain region 40 may contain semiconductor material that is doped with an n-type dopant, such as phosphorus and/or arsenic, to provide n-type conductivity. As used herein, the term "source/drain region" means a doped region of semiconductor material that can function as either a source or a drain of the field-effect transistor 34. In an embodiment, the source/drain region 38 may define a source region of the field-effect transistor 34, and the source/drain region 40 may define a drain region of the field-effect transistor 34.

A well may be formed in the semiconductor layers 12, 30, before forming the source/drain region 38 and the source/drain region 40, by ion implantation of a dopant having an opposite conductivity type from the source/drain region 38 and the source/drain region 40. A portion of the well in the semiconductor layers 12, 30 between the source/drain region 38 and the source/drain region 40 may constitute a body or channel region 46 of the field-effect transistor 34. The source/drain region 38 adjoins the channel region 46 along a junction 26 across which the conductivity type of the semiconductor material changes. The channel region 46 is disposed in a vertical direction beneath the gate 36. The field-effect transistor 34 may include sidewall spacers 45 disposed on the sidewalls of the gate 36. In an embodiment, the sidewall spacers 45 may be comprised of a dielectric material, such as a combination of layers of silicon dioxide and silicon nitride. The field-effect transistor 34 may also include other features, such as halo regions and lightly-doped drain extensions.

The defect region 28 is disposed adjacent to the lower portion of the source/drain region 38. The channel region 46 is disposed in a lateral direction between the defect region 28 and the source/drain region 40, and the defect region 28 is disposed in a lateral direction between the channel region 46 and the source/drain region 38. The defect region 28 may surround the lower portion of the source/drain region 38 and a lower portion of the junction 26 between the source/drain region 38 and the channel region 46. In an embodiment, the defect region 28 may overlap with the lower portion of the junction 26. The defect region 28 does not extend into the channel region 46 of the field-effect transistor 34. The source/drain region 40 of the field-effect transistor 34 lacks a defect region similar to the defect region 28, which produces an asymmetry in the device layout.

The defects of the defect region 28 may be effective to modify the source junction current and floating body to eliminate the floating body effect associated with a partially-depleted field-effect transistor 34. In that regard, the defects (e.g., dislocations) in the defect region 28 may create recombination centers that, during operation of the field-effect transistor 34, mitigate the floating body effect. The mitigation of the floating body effect by the defect region 28 may improve the body time constant for the field-effect transistor 34 without degrading baseline device performance embodied by factors such as drain-induced barrier lowering. The channel region 46 of the field-effect transistor 34 and the source/drain region 40 of the field-effect transistor 34 are free from defects resulting from the amorphization and recrystallization forming the defect region 28.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features "overlap" if a feature extends over, and covers a part of, another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure for a field-effect transistor, the structure comprising:
one or more semiconductor layers;
a gate on the one or more semiconductor layers;
a first source/drain region including a first portion in the one or more semiconductor layers and a second portion in the one or more semiconductor layers; and
a defect region in the one or more semiconductor layers, the defect region adjacent to the first portion of the first source/drain region.

2. The structure of claim 1 wherein the one or more semiconductor layers include a first semiconductor layer and a second semiconductor layer on the first semiconductor layer, and the second semiconductor layer is disposed fully between the defect region and the gate.

3. The structure of claim 2 wherein the first portion of the first source/drain region is disposed in the first semiconductor layer, and the second portion of the first source/drain region is disposed in the second semiconductor layer.

4. The structure of claim 3 wherein the first semiconductor layer adjoins the second semiconductor layer along an interface, the gate is disposed on the second semiconductor layer, and the interface is disposed between the defect region and the second portion of the first source/drain region.

5. The structure of one of claims 2 to 4 further comprising:
a substrate; and
a dielectric layer on the substrate,
wherein the first semiconductor layer adjoins the second semiconductor layer along an interface, and the defect region is disposed fully between the second semiconductor layer and the dielectric layer, and, optionally, wherein the structure further comprises a silicon-on-insulator substrate that includes the first semiconductor layer, the dielectric layer, and the substrate.

6. The structure of one of claims 2 to 5 wherein the second semiconductor layer is a homoepitaxial layer that comprises the same semiconductor material as the first semiconductor layer.

7. The structure of one of claims 1 to 6 wherein the defect region surrounds the first portion of the first source/drain region, and/or wherein the first source/drain region is a source region of the field-effect transistor.

8. The structure of one of claims 1 to 7 further comprising:
a second source/drain region in the one or more semiconductor layers; and
a channel region in the one or more semiconductor layers, the channel region disposed beneath the gate between the first source/drain region and the second source/drain region,
wherein the channel region is disposed between the defect region and the second source/drain region.

9. The structure of claim 8 wherein the channel region is adjacent to the defect region, and/or wherein the channel region is free of defects.

10. The structure of claim 8 or claim 9 wherein the first source/drain region is a source region of the field-effect transistor, and the second source/drain region is a drain region of the field-effect transistor.

11. The structure of one of claims 8 to 10 wherein the defect region is disposed between the channel region and the first source/drain region, and/or wherein the second source/drain region is free of defects.

12. The structure of one of claims 1 to 11 wherein the defect region comprises dislocations.

13. A method of forming a structure for a field-effect transistor, the method comprising:
forming a defect region in a first semiconductor layer;
forming a second semiconductor layer on the first semiconductor layer;
forming a gate on the second semiconductor layer; and
forming a source/drain region including a first portion in the first semiconductor layer and a second portion in the second semiconductor layer,
wherein the defect region is adjacent to the first portion of the source/drain region.

14. The method of claim 13 wherein the second semiconductor layer is formed after forming the defect region in the first semiconductor layer, and, optionally, wherein the source/drain region is formed in a portion of the second semiconductor layer and the recrystallized semiconductor material of the first semiconductor layer.

15. The method of claim 13 or 14 wherein forming the defect region in the first semiconductor layer comprises:
disordering a crystal structure of a portion of the first semiconductor layer; and
converting the portion of the first semiconductor layer to recrystallized semiconductor material and the defect region.
